# EUROPEAN PATENT APPLICATION

(11) **EP 4 087 130 A1**
(43) Date of publication of application: **09.11.2022**
(21) Application number: 20908971.3
(22) Date of filing: 06.05.2020
(51) Int. Cl.: H03H 9/15

(54) **BULK ACOUSTIC RESONATOR WITH BOTTOM ELECTRODE AS GAP ELECTRODE, AND FILTER AND ELECTRONIC DEVICE**

(30) Priority: 31.12.2019 CN 201911424758
(71) Applicant: Rofs Microsystem (Tianjin) Co., Ltd, Tianjin 300462 (CN)
(72) Inventor: PANG, Wei, Tianjin 300072 (CN); XU, Yang, Tianjin 300462 (CN); HAO, Long, Tianjin 300072 (CN); YANG, Qingrui, Tianjin 300072 (CN); ZHANG, Menglun, Tianjin 300072 (CN)
(74) Representative: Meyer-Dulheuer MD Legal Patentanwälte PartG mbB
(86) International application number: PCT/CN2020/088729
(87) International publication number: WO 2021/135019

(57) **Abstract**

Disclosed is a bulk acoustic resonator. The bulk acoustic resonator includes: a substrate; a bottom electrode; a top electrode; and a piezoelectric layer arranged between the bottom electrode and the top electrode, wherein the bottom electrode includes a lower bottom electrode and an upper bottom electrode, the lower bottom electrode is far away from the piezoelectric layer and is in a concave shape, the upper bottom electrode protrudes towards the piezoelectric layer and is in a convex shape, a gap layer is provided between the lower bottom electrode and the upper bottom electrode, and the gap layer forms an acoustic mirror of the resonator, and the lower bottom electrode and the upper bottom electrode are electrically connected to each other at pin and non-pin ends thereof. Further disclosed are a filter provided with the resonator, and an electronic device with the filter or the resonator.

## Description

### TECHNICAL FIELD

The present disclosure relates to the field of semiconductors, and in particular, to a bulk acoustic wave resonator, a filter, and an electronic device having the resonator or filter.

### BACKGROUND

As basic elements of an electronic apparatus, electronic devices have been widely applied, and their applications cover mobile phones, automobiles, home appliances and the like. In addition, technologies such as artificial intelligence, Internet of Things and 5G communication that will change the world in the future still need and rely on the electronic devices.

As an important member of the piezoelectric devices, a Film Bulk Acoustic Resonator (FBAR, also referred to as a bulk acoustic wave resonator (BAW)) is very important in the field of communication, and especially, an FBAR filter has gained a growing market share in the field of radio frequency filters. The traditional surface acoustic wave (SAW) filters and ceramic filters are gradually replaced by the FBAR filters due to their small size, high resonant frequency, high quality factor, large power capacity, good roll-off effect, and other excellent characteristics. Such the FBAR filters are used widely in the field of wireless communication radio frequency, and can be also applicable to the sensing filed such as biology, physics, and medicine due to their high sensitivity.

The current wireless electronic products require increasingly higher energy consumption, and wireless transceivers are widely used and have energy consumption. The manufacturers constantly raise higher requirements for insertion loss of filter products. In order to achieve lower insertion loss of the filter, it is required to further improve a Q value of the resonator.

### SUMMARY

In order to improve the Q value of a bulk acoustic wave resonator, the present disclosure is provided.

According to an aspect of embodiments of the present disclosure, there is provided a bulk acoustic wave resonator that includes a substrate, a bottom electrode, a top electrode, and a piezoelectric layer. The piezoelectric layer is provided between the bottom electrode and the top electrode. The bottom electrode includes a lower bottom electrode and an upper bottom electrode. The lower bottom electrode has a downward concave shape and is arranged away from the piezoelectric layer. The upper bottom electrode protrudes toward the piezoelectric layer to form an upward convex shape. The lower bottom electrode and the upper bottom electrode form a gap layer therebetween. The gap layer forms an acoustic mirror of the resonator. The lower bottom electrode and the upper bottom electrode are electrically connected with each other at both a pin end and a non-pin end of the bottom electrode.

An embodiment of the present disclosure also relates to a filter including the above bulk acoustic wave resonator.

An embodiment of the present disclosure also relates to an electronic device including the filter or the resonator as described above.

### BRIEF DESCRIPTION OF DRAWINGS

The following description and drawings can facilitate to understand these and other features and advantages in various embodiments disclosed in the present disclosure. The same reference signs in the drawings always indicate the same components.
FIG. 1A is a schematic sectional view of a bulk acoustic wave resonator according to an exemplary embodiment of the present disclosure.
FIG. 2 is a schematic sectional view of a bulk acoustic wave resonator according to an exemplary embodiment of the present disclosure, in which a wing structure and a bridge structure are provided on a top electrode on a basis of the structure of FIG. 1.
FIG. 3 is a schematic sectional view of a bulk acoustic wave resonator according to an exemplary embodiment of the present disclosure, in which a protrusion and/or recess structure is provided on a top electrode on a basis of the structure of FIG. 2.
FIG. 4 is a schematic sectional view of a bulk acoustic wave resonator according to an exemplary embodiment of the present disclosure, in which a gap layer is provided between an upper bottom electrode and a piezoelectric layer.
FIG. 5 is a schematic sectional view of a bulk acoustic wave resonator according to an exemplary embodiment of the present disclosure, in which a gap layer is formed in a piezoelectric layer.
FIG. 6 is a schematic sectional view of a bulk acoustic wave resonator according to an exemplary embodiment of the present disclosure, in which a gap layer is provided between an upper bottom electrode and a piezoelectric layer and the top electrode is provided with a wing structure and a bridge structure.
FIG. 7 is a schematic sectional view of a bulk acoustic wave resonator according to an exemplary embodiment of the present disclosure, in which a lower bottom electrode includes a first lower bottom electrode and a second lower bottom electrode that are concave and attached to each other.
FIG. 8 is a schematic sectional view of a bulk acoustic wave resonator according to an exemplary embodiment of the present disclosure, in which a lower bottom electrode includes a first lower bottom electrode and a second lower bottom electrode that are concave, and a gap is formed between the first lower bottom electrode and the second lower bottom electrode.
FIG. 9 is a schematic sectional view of a bulk acoustic wave resonator according to an exemplary embodiment of the present disclosure, in which a bottom electrode includes a first bottom electrode and a second bottom electrode, the first bottom electrode is concave and the second bottom electrode is flat.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

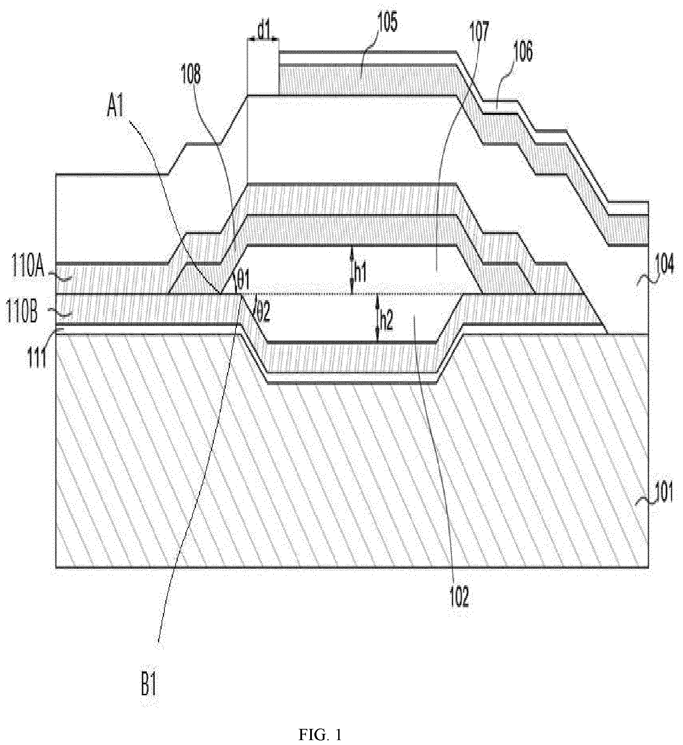

FIG. 1 is a schematic sectional view of a bulk acoustic wave resonator according to an exemplary embodiment of the present disclosure. In FIG. 1, reference numbers are described as follows.
101: Substrate, which may be made of a material such as monocrystalline silicon, gallium arsenide, sapphire, and quartz.
102: Lower acoustic mirror (a boundary is indicated by a dotted line in the figure) or a lower acoustic cavity, which is a trapezoidal cavity in a cross section in this embodiment. A distance between a lower bottom surface of the cavity and an interface is h2, and the interface is indicated by a dotted line and corresponds to an interface between an upper bottom electrode and a lower bottom electrode of a bottom electrode in this embodiment. An angle between an inclined sidewall of the cavity and the interface is θ2 in a range of 15 to 75 degrees.
103: Bottom electrode (an electrode pin), which may be made of a material such as molybdenum, ruthenium, gold, aluminum, magnesium, tungsten, copper, titanium, iridium, osmium, chromium, or composites or alloys thereof.
104: Piezoelectric film layer or piezoelectric layer, which may be made of a material such as aluminum nitride, zinc oxide, and PZT and contains the above materials doped with a certain atomic ratio of rare earth element.
105: Top electrode (an electrode pin), which may be made of a material such as molybdenum, ruthenium, gold, aluminum, magnesium, tungsten, copper, titanium, iridium, osmium, chromium, or composites or alloys thereof.
106: Passivation layer provided on a surface of the top electrode. The passivation layer is made of a material such as aluminum nitride, silicon dioxide, silicon nitride, silicon carbide, or metal oxide or nitride.
107: Upper acoustic mirror (of which a boundary is indicated by a dotted line in the figure) or an upper trapezoidal cavity, which is a trapezoidal cavity in a cross section in this embodiment. A distance between an upper top surface of the cavity and an interface is h1, and the interface is indicated by a dotted line and corresponds to an interface between the upper bottom electrode and the lower bottom electrode of the bottom electrode in this embodiment. An angle between an inclined sidewall of the cavity and the interface is θ1 in a range of 15 to 75 degrees.
108: Seed layer with high crystal orientation, which may be made of a material, such as AIN.
110A: Upper bottom electrode (an electrode pin), which may be made of a material such as molybdenum, ruthenium, gold, aluminum, magnesium, tungsten, copper, titanium, iridium, osmium, chromium, or composites or alloys thereof.
110B: Lower bottom electrode (an electrode pin), which may be made of a material such as molybdenum, ruthenium, gold, aluminum, magnesium, tungsten, copper, titanium, iridium, osmium, chromium, or composites or alloys thereof.
111: Seed layer.

In the embodiment shown in FIG. 1, the lower bottom electrode 110B has a concave shape that is depressed downwardly away from the piezoelectric layer 104, and the upper bottom electrode 110A has a convex shape that is projected upwardly toward the piezoelectric layer 104. A gap layer is provided between the lower bottom electrode 110B and the upper bottom electrode 110A, and is formed by the trapezoidal cavity 107 and the trapezoidal cavity 102 in FIG. 1. The gap layer forms an acoustic mirror of a resonator. As shown in FIG. 1, the lower bottom electrode 110B and the upper bottom electrode 110A are electrically connected to each other at a pin end and a non-pin end of the bottom electrode.

In an embodiment of the present disclosure, the seed layers 108 and 111 may not be provided.

The upper bottom electrode and the lower bottom electrode form a gap electrode with the upward convex and downward concave shape, and are electrically connected to each other at the pin end and the non-pin end, thereby improving the Q value of the resonator.

When the resonator operates, an alternating electric field is applied to the piezoelectric layer 104 through the electrodes. Since acoustic energy and electrical energy are coupled and converted into each other, a current flows through the electrodes. The bottom electrode of this embodiment has a double-layered electrode parallel structure such that electrical loss of the resonator can be effectively reduced. The piezoelectric layer generates sound waves under excitation of the alternating electric field. When the sound waves are conducted downwardly to an interface between the gap layer in the bottom electrode and the upper bottom electrode 110A, energy of the sound waves is reflected back to the piezoelectric layer 104 because acoustic impedances of air and the electrodes are greatly mismatched. However, the energy of the sound waves cannot enter the lower bottom electrode 110B. On the one hand, the electrode structure containing the gap layer in the present disclosure can significantly reduce the electrical loss of the resonator, which is indicated by an improved Q value at and near a series resonance frequency. On the other hand, the air gap functions to acoustically isolate the lower bottom electrode 110B such that negative influence of the lower bottom electrode 110B on the resonator performance can be substantially avoided.

The gap layer is a full gap with the upward convex and downward concave shape, a gap height is higher than a typical amplitude of the resonator (about 10 nm), which facilitates acoustic energy decoupling between the lower bottom electrode 110B and a resonant cavity when the resonator operates at a high power. The resonant cavity is a composite structure formed by the top electrode 105, the piezoelectric layer 104, and the upper bottom electrode 110A in this embodiment).

In an embodiment of the present disclosure, a sum of h1 and h2 is greater than 1 um, and further greater than 1.8 um.

Furthermore, in the above structure, a lower bottom boundary of the upper trapezoidal cavity 107 is located outside or at an outer side of an upper bottom boundary of the lower trapezoidal cavity 102. The non-pin end of the top electrode 105 is located insider or at an inner side of the upper bottom boundary of the upper trapezoidal cavity 107, and a distance between a non-pin end face and the upper bottom boundary is d1. In other words, a boundary of an effective region of the resonator determined by the top electrode, for example an edge of the non-pin end of the top electrode in FIG. 1, is spaced apart from an upper inclined surface in a lateral direction of the resonator or located at an inner side of the upper inclined surface in the lateral direction of the resonator. The inclined side wall herein corresponds to the upper inclined surface of the gap layer located at an edge of the upwardly convex shape, and more specifically, it corresponds to a waist portion between an upper bottom and a lower bottom of the upper trapezoidal cavity 107.

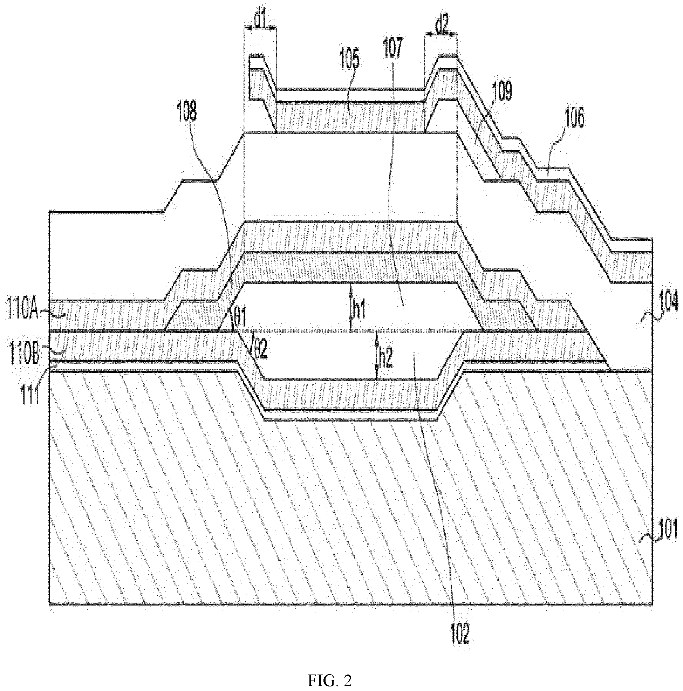

Furthermore, the inclined sidewall or the upper inclined surface (a left waist portion in FIG. 2) of the upper trapezoidal cavity 107 can generate coupling resonance with the wing structure, such that they can interact with each other to enhance performance of the resonator. A left side of the upper trapezoidal cavity 107 with the inclined sidewall or upper inclined surface in FIG. 1 actually provides an inclined cantilever beam to the resonator, and increases a reflection interface between the inclined cantilever beam and a lateral cantilever beam, which corresponds to a section d1 of the upper bottom of the upper trapezoidal cavity. Accordingly, the sound waves are reflected and refracted at the reflection interface, and finally resonance occurs at both the lateral cantilever beam and the inclined cantilever beam at a portion with a specific dimension. Therefore, energy leaking from the effective region to an asymmetric flexural mode of the cantilever beam portions can be effectively reflected back to a primary mode of the resonator.

As shown in FIG. 1, a boundary A1 (left and right sides in FIG. 1) of an upper gap portion (i.e., the upper trapezoidal cavity 107) at a first interface is located at an outer side of a boundary B1 of a lower gap portion (i.e., the lower trapezoidal cavity 102) at the first interface. In a specific example shown in FIG. 1, the upper gap portion and the lower gap portion respectively have an upper gap trapezoidal shape and a lower gap trapezoidal shape in a longitudinal section passing through the pin end of the bottom electrode, and the first interface forms bottom edges of the two trapezoidal shapes.

In an embodiment of the present disclosure, a value of d1 may be configured to obtain a larger Q value of the resonator.

FIG. 2 is a schematic sectional view of a bulk acoustic wave resonator according to an exemplary embodiment of the present disclosure. As shown in FIG. 2 on a basis of the structure of FIG. 1, the top electrode 105 is provided with the wing structure and the bridge structure. As shown in FIG. 2, a starting point of the bridge structure on the horizontal surface of the piezoelectric layer is located within the boundary of the upper bottom of the upper trapezoidal cavity 107, and a distance between the starting point and the boundary is d2.

The inclined sidewall (right side in FIG. 2) of the upper trapezoidal cavity 107 can generate coupling resonance with the gap 109 formed by the bridge structure, such that the inclined sidewall and the gap 109 can interact with each other to enhance the performance of the resonator. Aright side of the upper trapezoidal cavity 107 with the inclined sidewall or upper inclined surface in FIG. 2 actually provides an inclined cantilever beam to the resonator, and increases a reflection interface between the inclined cantilever beam and a lateral cantilever beam, which corresponds to a section d2 of the upper bottom of the upper trapezoidal cavity. Accordingly, the acoustic waves are reflected and refracted at the reflection interface, and finally resonance occurs at both the lateral cantilever beam and the inclined cantilever beam at a portion with a specific dimension. Therefore, energy leaking from the effective region to an asymmetric flexural mode of the cantilever beam portions can be effectively reflected back to a primary mode of the resonator.

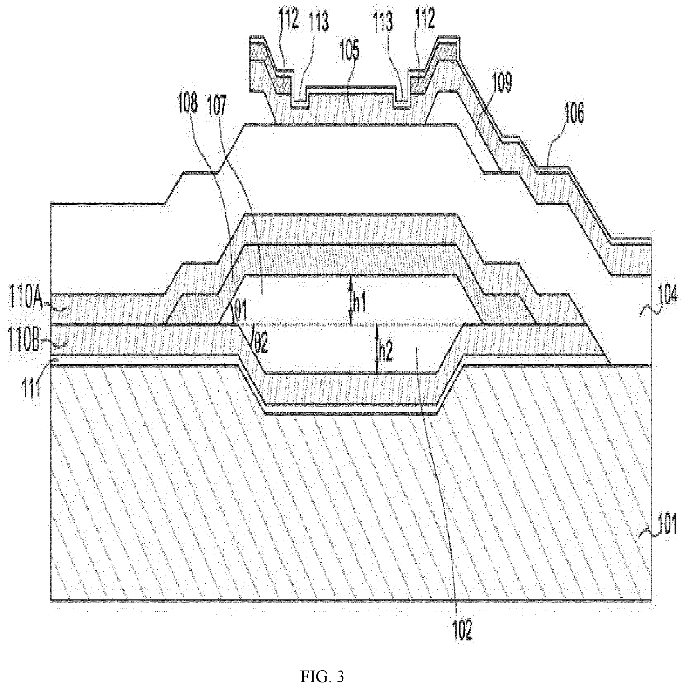

FIG. 3 is a schematic sectional view of a bulk acoustic wave resonator according to an exemplary embodiment of the present disclosure, in which a protrusion structure 112 and/or a recess structure 113 are provided on the top electrode based on the structure of FIG. 2. It should be noted that the protrusion structure and the recess structure may be arranged in the structure as shown in FIG. 1.

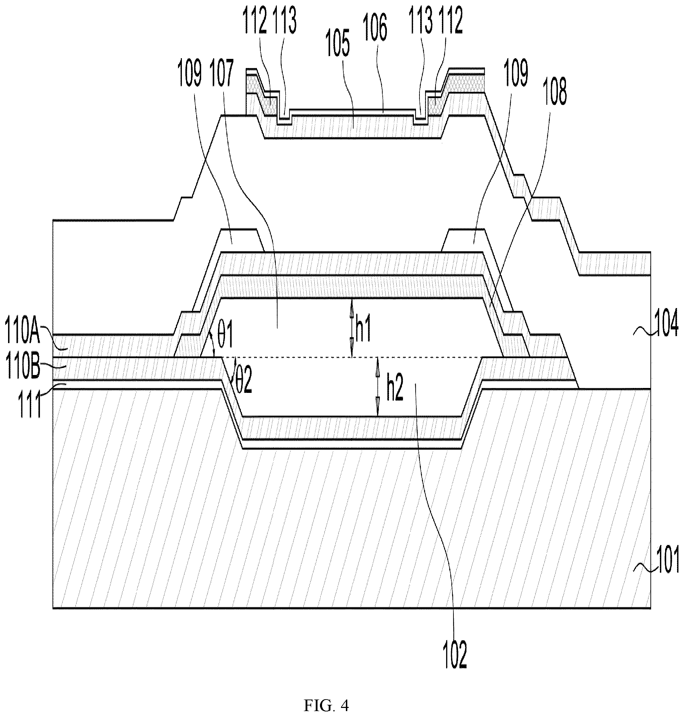

FIG. 4 is a schematic sectional view of a bulk acoustic wave resonator according to an exemplary embodiment of the present disclosure, in which a gap layer 109 is provided between the upper bottom electrode 110A and the piezoelectric layer 104. The gap layer 109 is configured in such a manner that the piezoelectric layer and the top electrode layer that are located above the gap layer 109 form a wing and bridge structure. In a further embodiment, optionally, a top electrode end face located at the non-pin end is located at an outer side of a starting point of the gap layer 109.

In the present disclosure, the starting point refers to a point where the gap or void is closest to a center of the resonator.

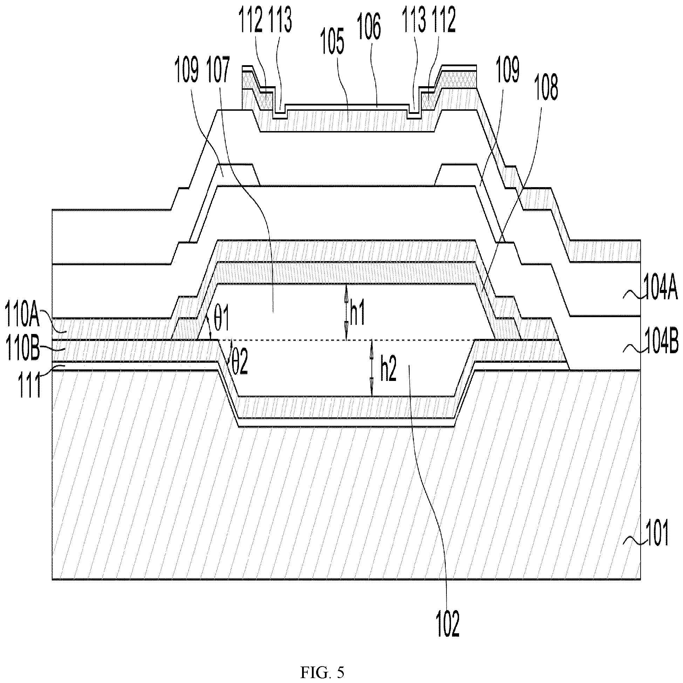

FIG. 5 is a schematic sectional view of a bulk acoustic wave resonator according to an exemplary embodiment of the present disclosure, in which a gap layer is formed in the piezoelectric layer. In FIG. 5, the piezoelectric layer includes a first piezoelectric layer 104A and a second piezoelectric layer 104B. The gap layer 109 is configured in such a manner that the piezoelectric layer and the top electrode layer that are located above the gap layer 109 form a wing and bridge structure.

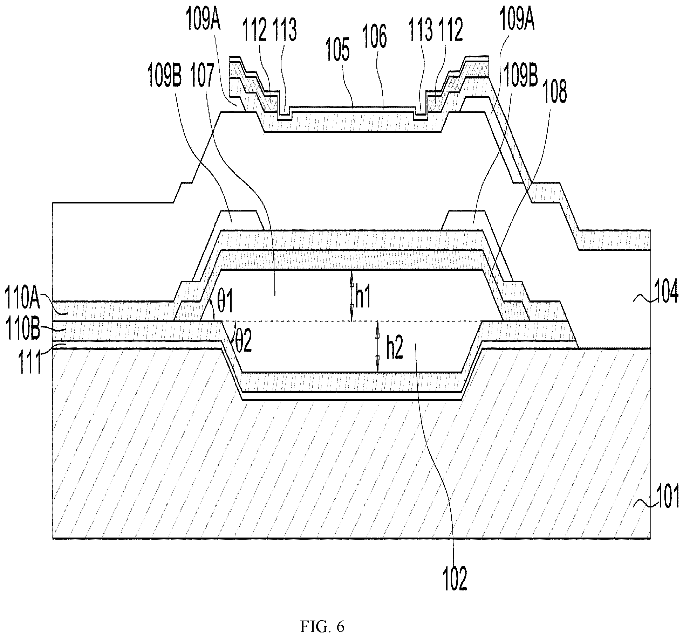

FIG. 6 is a schematic sectional view of a bulk acoustic wave resonator according to an exemplary embodiment of the present disclosure, in which a gap layer 109B is provided between the upper bottom electrode 110A and the piezoelectric layer 104, the top electrode is provided with a wing structure and a bridge structure, and the bridge structure and the wing structure form a gap 109A. The gap layer 109B is configured in such a manner that the piezoelectric layer located above the gap layer forms a wing and bridge structure. In a further embodiment, optionally, a starting point of the gap 109A is spaced apart from a starting point of the gap layer 109B in the lateral direction.

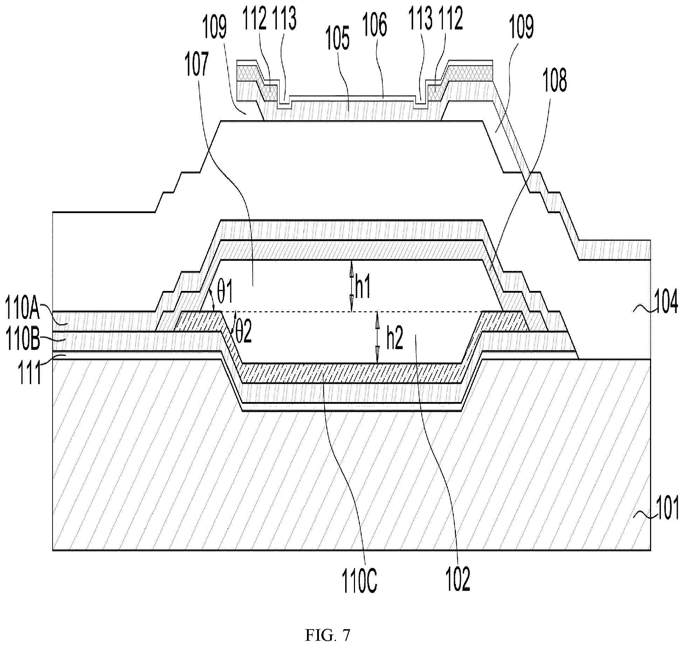

FIG. 7 is a schematic sectional view of a bulk acoustic wave resonator according to an exemplary embodiment of the present disclosure, in which the lower bottom electrode includes a first lower bottom electrode 110B and a second lower bottom electrode 110C, both of which are both concave and attached to each other, thereby further reducing a resistance of the lower bottom electrode. As shown in FIG. 7, both a pin end and a non-pin end of the second bottom electrode 110C extend beyond a recess of the substrate and are located outside the recess of the substrate.

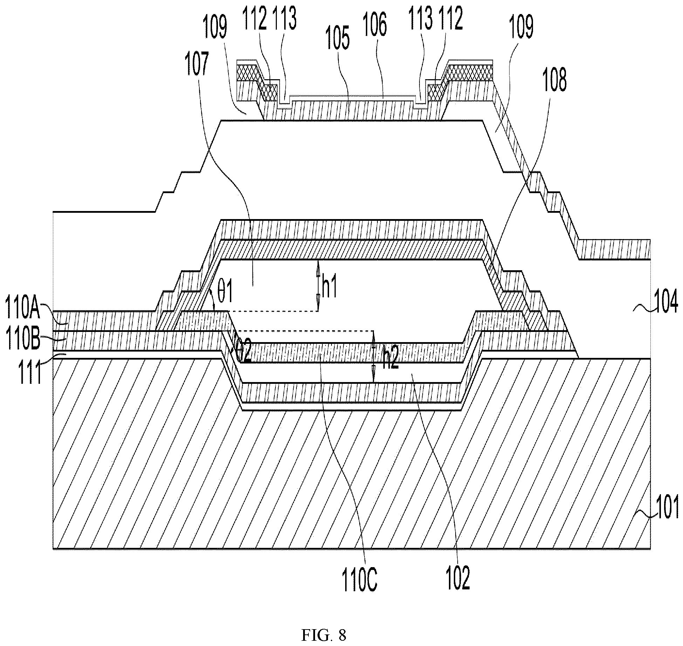

FIG. 8 is a schematic sectional view of a bulk acoustic wave resonator according to an exemplary embodiment of the present disclosure, in which both a first lower bottom electrode 110B and a second lower bottom electrode 110C are concave downwardly and form a gap therebetween. As shown in FIG. 8, both a pin end and a non-pin end of the second bottom electrode 110C extend beyond a recess of the substrate and are located outside the recess of the substrate.

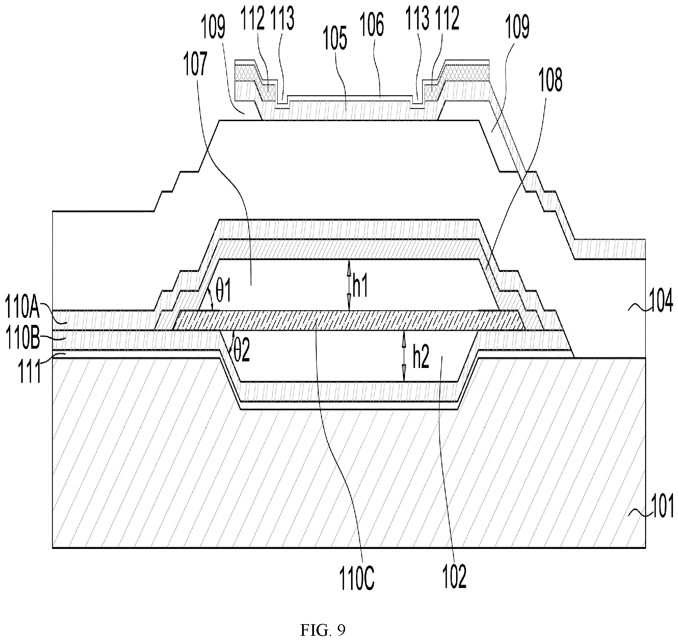

FIG. 9 is a schematic sectional view of a bulk acoustic wave resonator according to an exemplary embodiment of the present disclosure, in which the first lower bottom electrode 110B is concave downwardly and the second lower bottom electrode 110C is flat. In this way, a length of the second lower bottom electrode 110C is minimized, thereby reducing its resistance.

As shown in FIGS. 7 to 9, the top electrode is provided with the wing structure and the bridge structure, and the bridge structure and the wing structure form the gap 109.

In addition, as shown in FIGS. 7 to 9, the gap layer has upper inclined surfaces at both edges of the upward convex shape in the lateral direction, and the upward convex shape is configured to reach the top surface of the upper bottom electrode between the upper inclined surfaces. The gap layer is arranged between the top surface of the piezoelectric layer and the upper bottom electrode. The gap layer is a non-conductive dielectric layer, and includes an inclined section and a lateral section that are connected with each other. In a projection in a thickness direction of the resonator, the inclined section overlaps with at least part of the upper inclined surfaces, and the lateral section overlaps with at least part of the top surface of the upper bottom electrode.

In the present disclosure, the "inner side" refers to a side proximate to the center of the resonator in the lateral direction of the resonator, and the "outer side" refers to a side away from the center of the resonator in the lateral direction of the resonator. A direction toward the inside or an inward direction is a direction toward the center of the resonator, and a direction toward the inside or an outward direction is a direction away from the center of the resonator.

As can be understood by those skilled in the art, the bulk acoustic wave resonator according to the present disclosure can be configured to form a filter.

In view of the above, the present disclosure provides following technical solutions.
1. A bulk acoustic wave resonator includes:
   a substrate;
   a bottom electrode;
   a top electrode; and
   a piezoelectric layer provided between the bottom electrode and the top electrode,
   wherein the bottom electrode includes a lower bottom electrode and an upper bottom electrode, the lower bottom electrode has a downward concave shape and is arranged away from the piezoelectric layer, the upper bottom electrode protrudes toward the piezoelectric layer to form an upward convex shape, a gap layer is provided between the lower bottom electrode and the upper bottom electrode, the gap layer forms an acoustic mirror of the resonator, and the lower bottom electrode and the upper bottom electrode are electrically connected with each other at both a pin end and a non-pin end of the bottom electrode.
2. The resonator according to 1, wherein
   the gap layer has an upper inclined surface at an edge of the upward convex shape; and
   the top electrode defines a boundary of an effective region of the resonator, the boundary is spaced apart from the upper inclined surface in a lateral direction of the resonator or is located at an inner side of the upper inclined surface in the lateral direction of the resonator.
3. The resonator according to 2, wherein
   the lower bottom electrode and the upper bottom electrode are electrically connected to each other at the pin end and the non-pin end of the bottom electrode at a first interface, and the first interface divides the gap layer into an upper gap portion and a lower gap portion.
4. The resonator according to 3, wherein
   a boundary of the upper gap portion at the first interface is located at an outer side of a boundary of the lower gap portion at the first interface.
5. The resonator according to 4, wherein
   the upper gap portion and the lower gap portion respectively have an upper gap trapezoidal shape and a lower gap trapezoidal shape in a longitudinal section passing through the pin end of the bottom electrode, the first interface forms a bottom edge of the upper gap trapezoidal shape and a bottom edge of the lower gap trapezoidal shape, and a waist portion of the upper gap trapezoidal shape corresponds to the upper inclined surface.
6. The resonator according to 5, wherein
   the upper gap trapezoidal shape has a base angle at the pin end of the bottom electrode, and the base angle is in a range of 15 to 75 degrees; and/or
   the lower gap trapezoidal shape has a base angle at the pin end of the bottom electrode, and the base angle is in a range of 15 to 75 degrees.
7. The resonator according to 5 or 6, wherein
   a sum of heights of the upper gap trapezoidal shape and the lower gap trapezoidal shape is greater than 1 µm.
8. The resonator according to 7, wherein
   a sum of heights of the upper gap trapezoidal shape and the lower gap trapezoidal shape is greater than 1.8 µm.
9. The resonator according to any one of 2 to 8, wherein
   the top electrode has a non-pin end that is located at an inner side of the upper inclined surface in the lateral direction of the resonator, and the non-pin end of the top electrode is spaced apart from the upper inclined surface in the lateral direction.
10. The resonator according to 9, wherein
   the non-pin end of the top electrode is provided with a wing structure, and the wing structure is located between the non-pin end of the top electrode and the upper inclined surface in the lateral direction of the resonator; and/or
   the top electrode has an pin end that is provided with a bridge structure, and a starting point of the bridge structure is spaced apart from the upper inclined surface in the lateral direction of the resonator.
11. The resonator according to 10, wherein
   the top electrode is further provided with a protrusion and/or recess structure at an edge of the effective region of the resonator.
12. The resonator according to any one of 1 to 10, wherein
   two edges of the gap layer in a lateral direction of the upward convex shape each are provided with an upper inclined surface, the upward convex shape protrudes upwardly to a top surface of the upper bottom electrode between the upper inclined surfaces;
   a top surface of the piezoelectric layer and the upper bottom electrode form a gap layer therebetween, the gap layer is a non-conductive dielectric layer, and the gap layer includes an inclined section and a lateral section connected with each other; and
   in a projection in a thickness direction of the resonator, the inclined section overlaps with at least part of the upper inclined surfaces, and the lateral section overlaps with at least part of the top surface of the upper bottom electrode.
13. The resonator according to 12, wherein
   the gap layer is arranged between the upper bottom electrode and the piezoelectric layer, the inclined section covers at least part of the upper inclined surfaces, and the lateral section covers at least part of the top surface of the upper bottom electrode; or
   the gap layer is arranged between the piezoelectric layers.
14. The resonator according to 12 or 13, wherein
   the non-pin end of the top electrode is attached to the top surface of the piezoelectric layer; and
   a projection of an end face of the non-pin end of the top electrode in the thickness direction of the resonator is located within a range of the gap layer.
15. The resonator according to 12 or 13, wherein
   the top electrode is further provided with a wing structure and/or a bridge structure; and
   in the lateral direction of the resonator, a starting point of the gap layer is located at an inner side of a starting point of a corresponding one of the wing structure and the bridge structure, or the starting point of the gap layer is located at an outer side of the starting point of the corresponding one of the wing structure and the bridge structure.
16. The resonator according to any one of 1 to 10, wherein
   the substrate is provided with a substrate recess at an upper surface thereof;
   the lower bottom electrode includes a first lower bottom electrode and a second lower bottom electrode, the second lower bottom electrode is arranged above the first lower bottom electrode, the first lower bottom electrode and the second lower bottom electrode are electrically connected with each other at both the pin end and the non-pin end of the bottom electrode, and the second lower bottom electrode has a pin end and a non-pin end, which are both extend beyond the substrate recess and are located at an outer side of the substrate recess.
17. The resonator according to 16, wherein
   the first lower bottom electrode and the second lower bottom electrode are attached to each other; or
   the first lower bottom electrode and the second lower bottom electrode form a gap therebetween.
18. The resonator according to 17, wherein
   the first lower bottom electrode and the second lower bottom electrode each have a downward concave shape; or
   the first lower bottom electrode has a downward concave shape, and the second lower bottom electrode has a flat shape.
19. The resonator according to any one of 16 to 18, wherein
   the top electrode is further provided with a wing structure and/or a bridge structure.
20. The resonator according to any one of 1 to 19, wherein
   the substrate is provided with a substrate recess at an upper surface thereof, and the substrate recess has a generally trapezoidal sectional shape in a longitudinal section passing through the pin end of the bottom electrode; and
   the lower bottom electrode covers the substrate recess, and is attached to or covers an entire surface of the substrate recess.
21. A filter includes the bulk acoustic wave resonator according to any one of 1 to 20.
22. An electronic device includes the filter according to 21 or the bulk acoustic wave resonator according to any one of 1 to 20.

The electronic device herein includes, but is not limited to, intermediate products such as a RF front-end, filter and amplifier modules, and terminal products such as mobile phones, WIFI, and drones.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A bulk acoustic wave resonator, comprising:
a substrate;
a bottom electrode;
a top electrode; and
a piezoelectric layer provided between the bottom electrode and the top electrode,
wherein the bottom electrode comprises a lower bottom electrode and an upper bottom electrode, the lower bottom electrode has a downward concave shape and is arranged away from the piezoelectric layer, and the upper bottom electrode protrudes toward the piezoelectric layer to form an upward convex shape; and
wherein the lower bottom electrode and the upper bottom electrode form a gap layer therebetween, the gap layer forms an acoustic mirror of the resonator, and the lower bottom electrode and the upper bottom electrode are electrically connected with each other at both a pin end and a non-pin end of the bottom electrode.

2. The resonator according to claim 1, wherein the gap layer has an upper inclined surface at an edge of the upward convex shape; and
the top electrode defines a boundary of an effective region of the resonator, and the boundary is spaced apart from the upper inclined surface in a lateral direction of the resonator or is located at an inner side of the upper inclined surface in the lateral direction of the resonator.

3. The resonator according to claim 2, wherein the lower bottom electrode and the upper bottom electrode are electrically connected to each other at the pin end and the non-pin end of the bottom electrode at a first interface, and the first interface divides the gap layer into an upper gap portion and a lower gap portion.

4. The resonator according to claim 3, wherein a boundary of the upper gap portion at the first interface is located at an outer side of a boundary of the lower gap portion at the first interface.

5. The resonator according to claim 4, wherein the upper gap portion and the lower gap portion respectively have an upper gap trapezoidal shape and a lower gap trapezoidal shape in a longitudinal section passing through the pin end of the bottom electrode, the first interface forms a bottom edge of the upper gap trapezoidal shape and a bottom edge of the lower gap trapezoidal shape, and a waist portion of the upper gap trapezoidal shape corresponds to the upper inclined surface.

6. The resonator according to claim 5, wherein the upper gap trapezoidal shape has a base angle at the pin end of the bottom electrode, and the base angle is in a range of 15 to 75 degrees; and/or
the lower gap trapezoidal shape has a base angle at the pin end of the bottom electrode, and the base angle is in a range of 15 to 75 degrees.

7. The resonator according to claim 5 or 6, wherein a sum of heights of the upper gap trapezoidal shape and the lower gap trapezoidal shape is greater than 1 µm.

8. The resonator according to claim 7, wherein a sum of heights of the upper gap trapezoidal shape and the lower gap trapezoidal shape is greater than 1.8 µm.

9. The resonator according to any one of claims 2 to 8, wherein the top electrode has a non-pin end that is located at an inner side of the upper inclined surface in the lateral direction of the resonator, and the non-pin end of the top electrode is spaced apart from the upper inclined surface in the lateral direction.

10. The resonator according to claim 9, wherein the non-pin end of the top electrode is provided with a wing structure, and the wing structure is located between the non-pin end of the top electrode and the upper inclined surface in the lateral direction of the resonator; and/or
the top electrode has an pin end that is provided with a bridge structure, and a starting point of the bridge structure is spaced apart from the upper inclined surface in the lateral direction of the resonator.

11. The resonator according to claim 10, wherein the top electrode is further provided with a protrusion and/or recess structure at an edge of the effective region of the resonator.

12. The resonator according to any one of claims 1 to 10, wherein two edges of the gap layer in a lateral direction of the upward convex shape each are provided with an upper inclined surface, the upward convex shape protrudes upwardly to a top surface of the upper bottom electrode between the upper inclined surfaces;
the upper bottom electrode and a top surface of the piezoelectric layer form a gap layer therebetween, the gap layer is a non-conductive dielectric layer, and the gap layer comprises an inclined section and a lateral section connected with each other; and
in a projection in a thickness direction of the resonator, the inclined section overlaps with at least part of the upper inclined surfaces, and the lateral section overlaps with at least part of the top surface of the upper bottom electrode.

13. The resonator according to claim 12, wherein the gap layer is arranged between the upper bottom electrode and the piezoelectric layer, the inclined section covers at least part of the upper inclined surfaces, and the lateral section covers at least part of the top surface of the upper bottom electrode; or
the gap layer is arranged between the piezoelectric layers.

14. The resonator according to claim 12 or 13, wherein the non-pin end of the top electrode is attached to the top surface of the piezoelectric layer; and
a projection of an end face of the non-pin end of the top electrode in the thickness direction of the resonator is located within a range of the gap layer.

15. The resonator according to claim 12 or 13, wherein the top electrode is further provided with a wing structure and/or a bridge structure; and
in the lateral direction of the resonator, a starting point of the gap layer is located at an inner side of a starting point of a corresponding one of the wing structure and the bridge structure, or the starting point of the gap layer is located at an outer side of the starting point of the corresponding one of the wing structure and the bridge structure.

16. The resonator according to any one of claims 1 to 10, wherein the substrate is provided with a substrate recess at an upper surface thereof;
the lower bottom electrode comprises a first lower bottom electrode and a second lower bottom electrode, the second lower bottom electrode is arranged above the first lower bottom electrode, the first lower bottom electrode and the second lower bottom electrode are electrically connected with each other at both the pin end and the non-pin end of the bottom electrode, and the second lower bottom electrode has a pin end and a non-pin end, which are both extend beyond the substrate recess and are located at an outer side of the substrate recess.

17. The resonator according to claim 16, wherein the first lower bottom electrode and the second lower bottom electrode are attached to each other; or
the first lower bottom electrode and the second lower bottom electrode form a gap therebetween.

18. The resonator according to claim 17, wherein the first lower bottom electrode and the second lower bottom electrode each have a downward concave shape; or
the first lower bottom electrode has a downward concave shape, and the second lower bottom electrode has a flat shape.

19. The resonator according to any one of claims 16 to 18, wherein the top electrode is further provided with a wing structure and/or a bridge structure.

20. The resonator according to any one of claims 1 to 19, wherein the substrate is provided with a substrate recess at an upper surface thereof, and the substrate recess has a generally trapezoidal sectional shape in a longitudinal section passing through the pin end of the bottom electrode; and
the lower bottom electrode covers the substrate recess, and is attached to or covers an entire surface of the substrate recess.

21. A filter, comprising the bulk acoustic wave resonator according to any one of claims 1 to 20.

22. An electronic device, comprising the filter according to claim 21 or the bulk acoustic wave resonator according to any one of claims 1 to 20.
